# EUROPEAN PATENT APPLICATION

(11) **EP 1 054 297 A1**
(43) Date of publication of application: **22.11.2000**
(21) Application number: 99957400.7
(22) Date of filing: 01.12.1999
(51) Int. Cl.: G03F 7/42, H01L 21/027

(54) **PHOTORESIST STRIPPER AND METHOD OF STRIPPING**

(30) Priority: 03.12.1998 JP 34408998
(71) Applicant: Clariant International Ltd., 4132 Muttenz 1 (CH)
(72) Inventor: TAKEDA, Takashi Clariant (Japan) K.K., Ogasa-gun Shizuoka 437-1496 (JP); ARANO, Akio, Minoo-shi, Osaka 562-0045 (JP)
(74) Representative: Hütter, Klaus, Dr.
(86) International application number: JP9906728
(87) International publication number: WO0033139

(57) **Abstract**

[Problem to be solved] Intended to obtain a photoresist stripper which can remove a photoresist at low temperature and in a short time, which does not cause precipitation of insolubles upon rinsing with water after the removal treatment of the photoresist, and which has a function of preventing re-adhesion of the insolubles.

[Means for solving Problem] A material to be treated is immersed in a stripper containing a pyrimidinone compound represented by the following general formula (I) at a concentration of 10 to 100% by weight and then rinsed with water as necessary. 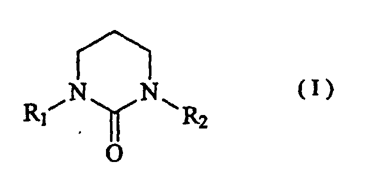 Wherein R₁ and R₂ each represent a hydrogen atom or an alkyl group containing 1 to 4 carbon atoms.

## Description

### [Detailed Explanation of the Invention]

### [Technical field to which the invention pertains]

The present invention relates to a photoresist stripper and a method of removing a photoresist with this stripper.

### [Prior art]

The photoresist is used as an etching mask or a mask for structuring treatment such as implantation (for example, ion-implantation) in various technical fields such as production of a semiconductor integrated circuit and display parts of a flat panel display (FPD) such as a liquid crystal display. When the photoresist is used as a masking material, the photoresist after used for its object is usually removed. For the removal of the photoresist, a stripper is used in many cases. As a photoresist stripper, there have been conventionally known a stripper comprising arylsulfonic acid(s) such as benzenesulfonic acid (Japanese Patent Application Laid-Open No. 54-153577), an acidic stripper wherein a chlorine-based organic solvent or a phenolic compound is blended with the above-mentioned stripper (Japanese Patent Application Laid-Open No. 62-35357), and an alkaline stripper comprising as an essential component alkanol amine such as monoethanol amine (Japanese Patent Application Laid-Open Nos. 62-49355 and 63-208043).

### [Problems to be solved by the invention]

As described above, various photoresist strippers have been known up to this time. However, these conventional strippers have a problem concerned with environmental safety such as waste-liquor treatment, a problem concerned with safety for the human body, and a problem of weak removing power, strong corrosive action on wiring materials, or insufficient removing power at a low temperature of the stripper. Further, in the removing treatment, a rinse with an organic solvent such as alcohol etc. and/or water is necessary after the removal of the photoresist. When rinses with an organic solvent and then with water are necessary, there is such a problem that the step becomes complicated. When a direct rinse with water is conducted without using an organic solvent such as alcohol, this step is not troublesome. However, insolubles precipitate at the time of the rinse and adhere again to the substrate, thus adversely affecting the performance of the device and decreasing the yield.

The object of the present invention is to provide a stripper which is free of the problems in all the conventional stripper described above, that is, to provide a stripper which, even when the temperature of stripper itself is normal temperature, can remove a photoresist rapidly and completely, which has less corrosive action on wiring materials etc., which does not cause precipitation of insolubles even upon rinsing with water after the removal treatment of the photoresist, which also functions as an agent for preventing re-adhesion, and which has high safety for the environment and the human body, as well as a method of removing a photoresist with this stripper.

### [Means for solving the problem]

The inventors eagerly made researches and investigations, and have found that the above-mentioned problems can be solved by using a stripper comprising a pyrimidinone compound represented by the following general formula (I) and made the present invention. 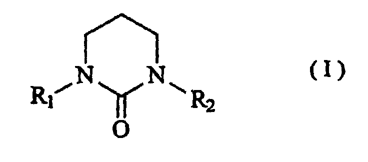 Wherein R₁ and R₂ each represent a hydrogen atom or an alkyl group containing 1 to 4 carbon atoms.

That is, the present invention relates to a photoresist stripper containing a pyrimidinone compound represented by the general formula (I) above.

The present invention also relates to a method of removing a photoresist wherein the photoresist stripper containing a pyrimidinone compound represented by the general formula (I) above is used.

Examples of the pyrimidinone compound represented by the general formula (I), which can be used in the present invention, include 1,3-dimethyl-3,4,5,6-tetrahydro-2(1H)-pyrimidinone (dimethylpropyleneurea), 1,3-diethyl-3,4,5,6-tetrahydro-2(1H)-pyrimidinone, 1,3-di-n-propyl-3,4,5,6-tetrahydro-2(1H)-pyrimidinone, and 1,3-di-iso-propyl-3,4,5,6-tetrahydro-2(1H)-pyrimidinone. These pyrimidinone compounds may be used alone or in combination of two or more in the stripper. In the present invention, the pyrimidinone compound itself, that is, a liquid of 100% of pyrimidinone compound may be used as the photoresist stripper. Further, the pyrimidinone compound may also be used as a mixture with other solvents. Examples of the solvent that may be mixed with the pyrimidinone compound include water; amines such as monoethanol amine and N-methylisopropylamine; amides such as dimethylformamide and N-methyl-2-pyrrolidone; glycol ethers such as ethylene glycol monoethyl ether, or acetates thereof; ketones such as acetone and methyl ethyl ketone; and dimethylsulfoxide. These solvents may be used alone or in combination of two or more. The content of the pyrimidinone compound in the stripper is preferably 10% by weight or more. If the content is less than 10% by weight, the effect based on the use of the pyrimidinone compound is small.

When the photoresist stripper containing the pyrimidinone compound of the present invention is used to remove a photoresist, a material to be treated may be immersed in the stripper at room temperature for several minutes. In this step, there are cases where removing power can be further improved by heating the stripper or by simultaneous use of ultrasonic waves. In the present invention, such manners may be used as necessary. By conducting stripping treatment using the stripper of the invention, even a photoresist which is post-baked at high temperature for improving adhesion property can easily be stripped.

A rinse with water after the stripping treatment makes it possible to remove easily the photoresist stripper containing the pyrimidinone compound on the material to be treated. According to conventional strippers, insolubles precipitate at the time of the rinse to adhere again to the substrate which was treated by the stripper, thus adversely affecting the performance of articles such as a semiconductor substrate. However, the stripper of the present invention does not have such problems. Therefore, semiconductor integrated circuits, FPD devices, etc. can be manufactured with a high yield.

The stripper of the present invention can be applied to any photoresist known in the art and good results are obtained in any cases. An especially preferred result can be obtained when the stripper of the present invention is applied to "novolok resin/quinonediazide compound"-based positive resists.

### [Examples]

The present invention will be more specifically described by way of Examples hereinafter. The present invention is not however limited to the Examples.

### (Stripping test)

### Examples 1-13 and Comparative Examples 1-4

Dimethylpropyleneurea (DMPU), monoethanol amine (MEA), N-methylisopropylamine (MIPA), N-methyl-2-pyrrolidone (NMP), and dimethylsulfoxide (DMSO) were used to prepare 17 types of strippers having the compositions of Examples 1 to 13 and Comparative Examples 1 to 4 shown in Table 1. Next, a resist pattern for using in the stripping test was prepared as below and then stripping treatments using 17 types of the strippers were conducted.

That is, a photoresist AZ® TFP-650 made by Clariant (Japan) K.K. was spin-coated onto a 4-inch silicon wafer, and then was baked on a hot plate at 100 °C for 90 seconds to obtain a resist film of 1.5 µm in thickness. This resist film was exposed to light with a g-line stepper (DSW6300, NA=0.30) made by GCA company. Thereafter, the film was developed with a 2.38% by weight of tetramethylammonium hydroxide aqueous solution (AZ® 300 MIF: made by Clariant (Japan) K.K.) at 23 °C for 60 seconds to form a resist pattern. Subsequently, the film was subjected to post-baking (heating treatment) at 120 °C or 140 °C for 120 seconds. The resultant film was immersed in the stripper having each of the compositions of Examples 1 to 13 and Comparative Examples 1 to 4 shown in Table 1 at each stripper temperature of 23 °C and 50 °C for 1 minute. Thus, each resist pattern was removed.

The observed results are shown in Table 1.

The evaluation of stripping was based on the following standards.
- ○: The photoresist was entirely removed.
- △: The photoresist not removed remained slightly.
- X: The photoresist not removed remained evidently.

**Table 1**

| | Constitution of Stripper | Temperature of Stripper 23°C | | Temperature of Stripper 50°C | |
|---|---|---|---|---|---|
| | | Post-baking Temperature | | Post-baking Temperature | |
| | | 120°C | 140°C | 120°C | 140°C |
| Example 1 | DMPU 100% | ○ | ○ | ○ | ○ |
| Example 2 | MEA :DMPU = 9:1 | ○ | △ | ○ | ○ |
| Example 3 | MEA :DMPU = 7:3 | ○ | ○ | ○ | ○ |
| Example 4 | MEA :DMPU = 5:5 | ○ | ○ | ○ | ○ |
| Example 5 | MIPA :DMPU = 9:1 | ○ | △ | ○ | ○ |
| Example 6 | MIPA :DMPU = 7:3 | ○ | ○ | ○ | ○ |
| Example 7 | MIPU :DMPU = 5:5 | ○ | ○ | ○ | ○ |
| Example 8 | NMP :DMPU = 9:1 | ○ | ○ | ○ | ○ |
| Example 9 | NMP :DMPU = 7:3 | ○ | ○ | ○ | ○ |
| Example 10 | NMP :DMPU = 5:5 | ○ | ○ | ○ | ○ |
| Example 11 | DMSO :DMPU = 9:1 | ○ | ○ | ○ | ○ |
| Example 12 | DMSO :DMPU = 7:3 | ○ | ○ | ○ | ○ |
| Example 13 | DMSO :DMPU = 5:5 | ○ | ○ | ○ | ○ |
| Comparative Example 1 | MEA 100% | X | X | △ | △ |
| Comparative Example 2 | MIPA 100% | X | X | △ | △ |
| Comparative Example 3 | NMP 100% | ○ | ○ | ○ | ○ |
| Comparative Example 4 | DMSO 100% | ○ | ○ | ○ | ○ |

### (Re-adhesion test)

On the assumption that a rinse with pure water is conducted after stripping, a test of re-adhesion upon rinsing with pure water was performed. The test in the following Examples 14 to 26 and Comparative Examples 5 to 8 was performed by adding given amounts of strippers containing a dissolved photoresist to water and by measuring the transparency of the stripper-added solutions. As described later, the results in this test have a correlation with results of actual rinsing.

### Examples 14-26 and Comparative Examples 5-8

A solvent was evaporated from a photoresist AZ® TFP-650 made by Clariant (Japan) K.K., to prepare a dry AZ® TFP-650. This was dissolved in each amount of 0.174, 0.348, 0.522, 0.696, 0.870 and 1.044 g into 10 g of a stripper having each of the compositions of Examples 14 to 26 and Comparative Examples 5 to 8 shown in Table 2. In the compositions, there were used dimethylpropyleneurea (DMPU), monoethanol amine (MEA), N-methylisopropylamine (MIPA), N-methyl-2-pyrrolidone (NMP), and dimethylsulfoxide (DMSO), as with Examples 1 to 13 and Comparative Examples 1 to 4. 2.5 ml of each of the dry AZ® TFP-650 -dissolved strippers was dropwise added to 300 ml of pure water. A muddy degree of the water (transparency) of the resultant solutions was observed according to the method for measuring transparency in "JIS K 0102 Test method of drained factory water". The transparency is measured as a depth immediately before a transparency disc which is being moved 0.2 cm by 0.2 cm cannot be observed. The results are shown in Table 2.

**Table 2**

| Additional Quantity (g) | | Transparency (cm) | | | | | |
|---|---|---|---|---|---|---|---|
| | | 0.174 | 0.378 | 0.522 | 0.696 | 0.870 | 1.044 |
| Example 14 | DMPU 100% | >30.0 | >30.0 | >30.0 | 29.6 | 27.4 | 26.0 |
| Example 15 | MEA :DMPU = 9:1 | >30.0 | >30.0 | >30.0 | >30.0 | >30.0 | 29.2 |
| Example 16 | MEA :DMPU = 7:3 | >30.0 | >30.0 | >30.0 | >30.0 | >30.0 | 29.2 |
| Example 17 | MEA :DMPU = 5:5 | >30.0 | >30.0 | >30.0 | >30.0 | >30.0 | 29.2 |
| Example 18 | MIPA :DMPU = 9:1 | >30.0 | >30.0 | >30.0 | >30.0 | 29.4 | 29.0 |
| Example 19 | MIPA :DMPU = 7:3 | >30.0 | >30.0 | >30.0 | >30.0 | 29.6 | 28.6 |
| Example 20 | MIPU :DMPU = 5:5 | >30.0 | >30.0 | >30.0 | >30.0 | >30.0 | 29.4 |
| Example 21 | NMP :DMPU = 9:1 | >30.0 | >30.0 | >30.0 | 29.6 | 26.8 | 24.6 |
| Example 22 | NMP :DMPU = 7:3 | >30.0 | >30.0 | >30.0 | 29.6 | 26.8 | 24.8 |
| Example 23 | NMP :DMPU = 5:5 | >30.0 | >30.0 | >30.0 | 29.4 | 27.0 | 25.0 |
| Example 24 | DMSO:DMPU = 9:1 | >30.0 | >30.0 | >30.0 | 28.8 | 26.2 | 24.2 |
| Example 25 | DMSO:DMPU = 7:3 | >30.0 | >30.0 | >30.0 | 29.0 | 26.2 | 24.0 |
| Example 26 | DMSO:DMPU = 5:5 | >30.0 | >30.0 | >30.0 | 29.0 | 26.4 | 24.2 |
| Comparative Example 5 | MEA 100% | >30.0 | >30.0 | >30.0 | 28.8 | 27.2 | 21.4 |
| Comparative Example 6 | MIPA 100% | >30.0 | >30.0 | >30.0 | 28.0 | 26.6 | 21.2 |
| Comparative Example 7 | NMP 100% | >30.0 | >30.0 | 26.8 | 20.0 | 9.2 | 4.6 |
| Comparative Example 8 | DMSO 100% | >30.0 | >30.0 | 26.2 | 19.2 | 8.4 | 3.2 |

Resist patterns were formed in the same way as in Examples 1 to 13, and then were subjected to post-baking (heating treatment) at 140 °C for 120 seconds. Subsequently, the resist patterns were removed by immersing them into the strippers with the constitutions of Examples 15, 19 and 23, and Comparative Example 7 at a stripper temperature of 23 °C for 1 minute. Next, they were rinsed with pure water. As a result, in the cases of using the strippers of Examples 15, 19 and 23, any insoluble was not observed. In the case of using the stripper of Comparative Example 7, insolubles were observed. This result demonstrates the correlative relationship between the result of the transparency according to the stripping test mentioned above and the practical effect of preventing re-adhesion.

### [Effect of the Invention]

Conventional photoresist strippers do not give sufficient stripping ability unless the temperature of the strippers is made high and much time is consumed. The stripper of the present invention can easily remove a photoresist at low temperature and in a short time. Moreover, there does not arise a phenomenon that, at the time of a rinse after stripping, insolubles precipitate and the insolubles adhere again to a material to be treated, such as a substrate. Additionally, the stripper of the present invention has a weak corrosive action on wiring materials and the like, and is excellent in safety for the environment and the human body. Therefore, the present stripper makes it possible to manufacture semiconductor integrated circuits, FPD devices and the like with a high yield and safety.

## Claims

1. A photoresist stripper comprising a pyrimidinone compound represented by the general formula (I): 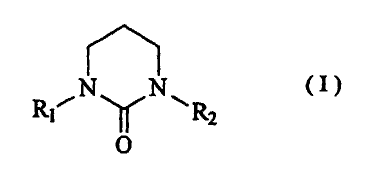 wherein R₁ and R₂ each represent a hydrogen atom or an alkyl group containing 1 to 4 carbon atoms.

2. A photoresist stripper according to claim 1 wherein the content of the pyrimidinone compound is in the range of 10 to 100% by weight.

3. A photoresist stripper according to claim 1 or 2 wherein the pyrimidinone compound is 1,3-dimethyl-3,4,5,6-tetrahydro-2(1H)-pyrimidinone.

4. A method of removing a photoresist wherein the photoresist stripper described in claim 1, 2 or 3 is used to remove the photoresist.
